# EUROPEAN PATENT APPLICATION

(11) **EP 4 597 545 A1**
(43) Date of publication of application: **06.08.2025**
(21) Application number: 22960748.6
(22) Date of filing: 26.09.2022
(51) Int. Cl.: H01L 21/205

(54) **SUBSTRATE PROCESSING METHOD, METHOD FOR MANUFACTURING SEMICONDUCTOR DEVICE, SUBSTRATE PROCESSING DEVICE, AND PROGRAM**

(71) Applicant: Kokusai Electric Corporation, Tokyo 101-0045 (JP)
(72) Inventor: OGAWA, Arito, Toyama-shi, Toyama 939-2393 (JP); SEINO, Atsuro, Toyama-shi, Toyama 939-2393 (JP)
(74) Representative: Bardehle Pagenberg Partnerschaft mbB Patentanwälte Rechtsanwälte
(86) International application number: PCT/JP2022/035643
(87) International publication number: WO 2024/069683

(57) **Abstract**

Provided is technology that makes it possible to improve film thickness uniformity and burying properties in the formation of a film. In the present invention, a cycle in which the following steps are executed in the following order on a substrate is repeated a prescribed number of times: (a) a step for supplying a first reforming gas, which is an inorganic halogen-element-containing gas; (b) a step for supplying a raw-material gas; (c) a step for supplying a second reforming gas, which is an inorganic halogen-element-containing gas; and (d) a step for supplying a reactant gas.

## Description

### TECHNICAL FIELD

The present disclosure relates to a method of processing a substrate, a method of manufacturing a semiconductor device, a substrate processing apparatus, and a program.

### BACKGROUND

In recent years, with miniaturization and complication of device geometries in an LSI manufacturing process, high step coverage and high filling characteristics are demanded in film formation (*see, e.g*., Patent Document 1).

### [Prior Art Documents]

### Patent Documents

Patent Document 1: Japanese laid-open publication No. 2017-69407

### SUMMARY

The present disclosure provides a technique capable of improving a film thickness uniformity and filling characteristics in film formation.

Other issues and novel features will become apparent from description of the present disclosure and accompanying drawings.

According to some embodiments of the present disclosure, there is provided a technique that includes performing a cycle, on a substrate, a predetermined number of times, wherein the cycle includes sequentially (in a below-described order) performing: (a) supplying a first modifying gas, which is an inorganic halogen element-containing gas, (b) supplying a precursor gas, (c) supplying a second modifying gas, which is an inorganic halogen element-containing gas, and (d) supplying a reaction gas.

According to the present disclosure, it is possible to improve a film thickness uniformity and filling characteristics in film formation.

### BRIEF DESCRIPTION OF DRAWINGS

FIG. 1 is a vertical sectional view schematically showing a vertical process furnace of a substrate processing apparatus according to some embodiments of the present disclosure.
FIG. 2 is a schematic diagram of a controller of a substrate processing apparatus according to some embodiments of the present disclosure, and is a diagram showing a control system of the controller in a block diagram.
FIG. 3 is a diagram explaining a method of processing a substrate according to some embodiments of the present disclosure.
FIG. 4 is a diagram showing supply amounts of respective gases in a film formation sequence according to some embodiments of the present disclosure.
FIG. 5 is a diagram explaining a progress of the method of processing the substrate shown in FIG. 3.
FIG. 6 is a diagram showing partial pressures of respective gases in a film formation sequence according to some embodiments of the present disclosure.
FIG. 7 is a diagram showing a film formation sequence according to a first modification.
FIG. 8 is a diagram showing a film formation sequence according to a second modification.
FIG. 9 is a diagram showing a film formation sequence according to a third modification.
FIG. 10 is a diagram showing a film formation sequence according to a fourth modification.
FIG. 11 is a diagram showing a film formation sequence according to a fifth modification.

### DETAILED DESCRIPTION

The following description will be given with reference to the drawings. However, in the following description, the same components are designated by the same reference numerals and repeated description thereof may be omitted. To make the description clearer, the drawings may be shown schematically compared to actual embodiments, but the drawings are merely examples and are not intended to limit the interpretation of the present disclosure. In addition, the drawings used in the following descriptions are schematic, and dimensional relationships, ratios of the respective components, and the like shown in the drawings may not match actual ones. In addition, dimensional relationships, ratios of the respective components, and the like may not match among multiple drawings.

Preferred embodiments of the present disclosure will be described below with reference to the drawings. A substrate processing apparatus 10 is constituted as an example of an apparatus used in a process of processing a substrate as a process of manufacturing a semiconductor device. First, the substrate processing apparatus used in the embodiments will be described. Specifically, the substrate processing apparatus is a semiconductor device manufacturing apparatus, and is used in a process of manufacturing a semiconductor device. In the following description, a configuration in which a substrate processing apparatus configured to perform a film-forming process or the like on multiple substrates (wafers) at a time is used as an example of the substrate processing apparatus will be described.

### (1) Configuration of Substrate Processing Apparatus

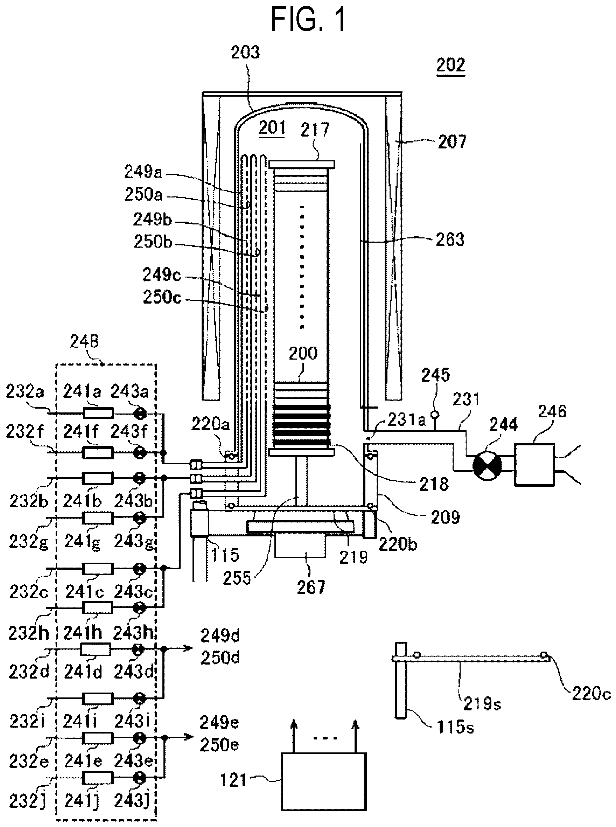

FIG. 1 is a schematic configuration diagram of a vertical process furnace of a substrate processing apparatus according to the present disclosure, in which a portion of the process furnace is shown in a vertical cross-sectional view. As shown in FIG. 1, a process furnace 202 includes a heater 207 as a heating mechanism (temperature regulator). The heater 207 is formed in a cylindrical shape and is installed vertically by being supported by a holding plate. The heater 207 also functions as an activator (an exciter) configured to activate (excite) a gas with heat.

A reaction tube 203 is disposed inside the heater 207 to be concentric with the heater 207. The reaction tube 203 is made of, for example, heat resistant material such as quartz (SiO₂) or silicon carbide (SiC), and is formed in a cylindrical shape with its upper end closed and its lower end opened. A manifold 209 is disposed to be concentric with the reaction tube 203 under the reaction tube 203. The manifold 209 is made of, for example, metal material such as stainless steel (SUS), and is formed in a cylindrical shape with both of its upper and lower ends opened. The upper end of the manifold 209 engages with the lower end of the reaction tube 203 to support the reaction tube 203. An O-ring 220a serving as a seal is provided between the manifold 209 and the reaction tube 203. Similar to the heater 207, the reaction tube 203 is vertically installed. A process container (reaction container) mainly includes the reaction tube 203 and the manifold 209. A process chamber 201 is formed in a hollow cylindrical area of the process container. The process chamber 201 is configured to be capable of accommodating wafers 200 as substrates. The wafers 200 are processed in the process chamber 201.

Nozzles 249a to 249e as first to fifth suppliers are installed in the process chamber 201 so as to penetrate a sidewall of the manifold 209. In FIG. 1, three nozzles (nozzles 249a to 249c) are depicted, and two nozzles (nozzles 249d and 249e) are not shown because they would complicate the drawing. The nozzles 249a to 249e are also referred to as first to fifth nozzles, respectively. The nozzles 249a to 249e are made of, for example, a heat-resistant material such as quartz or SiC. Gas supply pipes 232a to 232e are connected to the nozzles 249a to 249e, respectively. The nozzles 249a to 249e are different nozzles.

Mass flow controllers (MFCs) 241a to 241e, which are flow rate controllers (flow rate control parts), and valves 243a to 243e, which are opening/closing valves, are installed at the gas supply pipes 232a to 232e sequentially from upstream sides of gas flows, respectively. Gas supply pipes 232f to 232j are connected to the gas supply pipes 232a to 232e at downstream sides of the valves 243a to 243e, respectively. MFCs 241f to 241j and valves 243f to 243j are installed at the gas supply pipes gas supply pipes 232f to 232j sequentially from upstream sides of gas flows, respectively. The gas supply pipes 232a to 232j are made of, for example, a metal material such as SUS or the like.

The nozzles 249a to 249e are installed respectively in an annular space in a plane view between an inner wall of the reaction tube 203 and the wafers 200 so as to extend upward from a lower side to an upper side of the inner wall of the reaction tube 203 in an arrangement direction of the wafers 200. That is, the nozzles 249a to 249e are respectively installed in a region horizontally surrounding a wafer arrangement region in which the wafers 200 are arranged at a lateral side of the wafer arrangement region, along the wafer arrangement region. Gas supply holes 250a to 250d configured to supply gases are provided at side surfaces of the nozzles 249a to 249e, respectively. Each of the gas supply holes 250a to 250d is opened to oppose (face) an exhaust port 231a in a plane view, which enables the gas to be supplied toward the wafers 200. A plurality of gas supply holes 250a to 250d are provided from the lower side to the upper side of the reaction tube 203.

A precursor gas as a processing gas is supplied from the gas supply pipe 232a into the process chamber 201 via the MFC 241a, the valve 243a, and the nozzle 249a. As the precursor gas, for example, a halogen element-containing gas (a halogen-based gas) containing a halogen element, for example, a gas containing a metal element (a metal-containing gas) may be used. The halogen element referred to herein is, for example, fluorine (F), chlorine (Cl), bromine (Br), or iodine (I). As the halogen element-containing gas, for example, a chloride gas containing Cl is used. In the present disclosure, the term "precursor" may mean a "liquid precursor in a liquid state," a "precursor gas in a gaseous state," or both.

A first modifying gas (also called a first film formation inhibiting gas or a first inhibitor), which is an inorganic halogen element-containing gas, is supplied from a gas supply pipe 232b into the process chamber 201 via the MFC 241b, the valve 243b, and the nozzle 249b. As the first modifying gas, for example, a halogen element-containing gas, for example, a hydrogen halide gas may be used.

A reaction gas serving as a processing gas is supplied from the gas supply pipe 232c into the process chamber 201 via the MFC 241c, the valve 243c, and the nozzle 249c. As the reaction gas, for example, a nitrogen (N)-containing gas (nitriding gas, or nitriding agent) may be used.

A second modifying gas (also called a second film formation inhibiting gas or a second inhibitor), which is an inorganic halogen element-containing gas, is supplied from the gas supply pipe 232d into the process chamber 201 via the MFC 241d, the valve 243d, and the nozzle 249d. As the second modifying gas, for example, a halogen element-containing gas, for example, a hydrogen halide gas, may be used.

An etching gas is supplied from the gas supply pipe 232e into the process chamber 201 via the MFC 241e, the valve 243e, and the nozzle 249e.

An inert gas, for example, a nitrogen (N₂) gas, is supplied from the gas supply pipes 232f to 232j into the process chamber 201 via the MFCs 241f to 241j, the valves 243f to 243j, and the nozzles 249a to 249e, respectively. The N₂ gas acts as a purge gas, a carrier gas, a dilution gas, etc.

A precursor supply system mainly includes the gas supply pipe 232a, the MFC 241a, and the valve 243a. A first modifying gas supply system mainly includes the gas supply pipe 232b, the MFC 241b, and the valve 243b. A reaction gas supply system mainly includes the gas supply pipe 232c, the MFC 241c, and the valve 243c. A second modifying gas supply system mainly includes the gas supply pipe 232d, the MFC 241d, and the valve 243d. An etching gas supply system mainly includes the gas supply pipe 232e, the MFC 241e, and the valve 243e. An inert gas supply system mainly includes the gas supply pipes 232f to 232j, the MFCs 241f to 241j, and the valves 243f to 243j.

The first modifying gas and the second modifying gas may be the same. In this case, the nozzle 249d of the second modifying gas supply system is not used, and the nozzle 249b of the first modifying gas supply system is used to supply the first modifying gas and the second modifying gas into the process chamber 201. When this configuration is adopted, the second modifying gas supply system (the gas supply pipe 232d, the MFC 241d, and the valve 243d) and the inert gas supply system including the gas supply pipe 232i, the MFC 241i, and the valve 243i may be eliminated from the substrate processing apparatus shown in FIG. 1, thereby simplifying the configuration of the substrate processing apparatus.

One or the entirety of the above-described various supply systems may be constituted as an integrated supply system 248 in which the valves 243a to 243j, the MFCs 241a to 241j, etc. are integrated. The integrated supply system 248 is connected to each of the gas supply pipes 232a to 232j, and is configured such that operations of supplying various gases into the gas supply pipes 232a to 232j, i.e., opening and closing operations of the valves 243a to 243j, flow rate regulating operation by the MFCs 241a to 241j or the like, are controlled by a controller 121, which is described below.

An exhaust port 231a configured to exhaust an internal atmosphere of the process chamber 201 is installed at a lower side of the sidewall of the reaction tube 203. The exhaust port 231a is installed at a position opposing (facing) the nozzles 249a to 249e (gas supply holes 250a to 250e) with the wafers 200 interposed therebetween. The exhaust port 231a may be installed to extend from the lower side to the upper side of the sidewall of the reaction tube 203, i.e., along the wafer arrangement region. An exhaust pipe 231 is connected to the exhaust port 231a. A vacuum pump 246 as a vacuum exhauster is connected to the exhaust pipe 231 via a pressure sensor 245 as a pressure detector (pressure detection part) configured to detect an internal pressure of the process chamber 201, and an auto pressure controller (APC) valve 244 as a pressure regulator (pressure regulation part). The APC valve 244 is configured to be capable of performing or stopping a vacuum exhaust of an inside of the process chamber 201 by being opened or closed in a state where the vacuum pump 246 is actuated, and is also configured to be capable of regulating the internal pressure of the process chamber 201 by adjusting a degree of valve opening based on pressure information detected by the pressure sensor 245 in a state where the vacuum pump 246 is actuated. An exhaust system mainly includes the exhaust pipe 231, the APC valve 244, and the pressure sensor 245. The vacuum pump 246 may be included in the exhaust system.

A seal cap 219, which serves as a furnace opening lid configured to be capable of airtightly sealing a lower end opening of the manifold 209, is installed under the manifold 209. The seal cap 219 is made of, for example, a metal material such as stainless steel (SUS) or the like, and is formed in a disc shape. An O-ring 220b, which is a seal making contact with the lower end of the manifold 209, is installed on an upper surface of the seal cap 219. A rotator 267 configured to rotate a boat 217 described below, is installed under the seal cap 219. A rotary shaft 255 of the rotator 267 is connected to the boat 217 through the seal cap 219. The rotator 267 is configured to rotate the wafers 200 by rotating the boat 217.

The seal cap 219 is configured to be vertically moved up or down by a boat elevator 115 which is an elevator installed outside the reaction tube 203. The boat elevator 115 is constituted as a transfer apparatus (transfer mechanism) configured to load or unload (transfer) the wafers 200 into or out of the process chamber 201 by moving the seal cap 219 up or down. A shutter 219s, which serves as a furnace opening lid configured to be capable of hermetically sealing a lower end opening of the manifold 209 in a state where the seal cap 219 is lowered and the boat 217 is unloaded from the process chamber 201, is installed under the manifold 209. The shutter 219s is made of, for example, metal material such as SUS, and is formed in a disc shape. An O-ring 220c, which is a seal making contact with the lower end of the manifold 209, is installed on an upper surface of the shutter 219s. The opening/closing operation (such as elevation operation, rotation operation, or the like) of the shutter 219s is controlled by a shutter opening/closing mechanism 115s.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another, that is, the boat 217 is configured to arrange the wafers 200 to be spaced apart from each other. The boat 217 is made of, for example, heat resistant material such as quartz or SiC. Heat insulating plates 218 made of, for example, heat resistant material such as quartz or SiC are installed below the boat 217 in multiple stages. In the present disclosure, for example, when a numerical range is stated as 25 to 200, this means 25 or more and 200 or less. In other words, the numerical range includes 25 and 200. The same applies to numerical values stated in the present disclosure, such as pressure, flow rate, time, temperature, and the like, as well as the number of objects

A temperature sensor 263 serving as a temperature detector is installed in the reaction tube 203. Based on temperature information detected by the temperature sensor 263, a state of supplying electric power to the heater 207 is regulated such that a temperature distribution inside the process chamber 201 becomes a desired temperature distribution. The temperature sensor 263 is installed along the inner wall of the reaction tube 203.

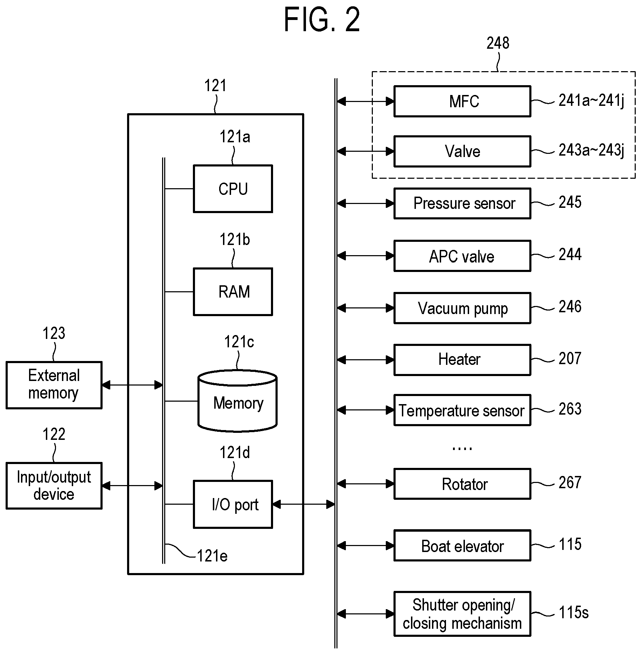

As shown in FIG. 2, a controller 121, which is a control part (control means or unit), is constituted as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 including, e.g., a touch panel or the like, is connected to the controller 121.

The memory 121c includes, for example, a flash memory, a hard disk drive (HDD), or the like. A control program that controls operations of a substrate processing apparatus, a process recipe in which sequences and conditions of substrate processing described below are written, and the like are readably stored in the memory 121c. The process recipe functions as a program combined to cause the controller 121 to perform each sequence in the substrate processing described below, to obtain an expected result. Hereinafter, the process recipe and the control program may be generally and simply referred to as a "program." Further, the process recipe may be simply referred to as a "recipe." When the term "program" is used herein, it may indicate a case of including the recipe, a case of including the control program, or a case of including both the recipe and the control program. The RAM 121b is configured as a memory area (work area) in which programs or data read by the CPU 121a are temporarily stored.

The I/O port 121d is connected to the MFCs 241a to 241j, the valves 243a to 243j, the pressure sensor 245, the APC valve 244, the vacuum pump 246, the temperature sensor 263, the heater 207, the rotator 267, the boat elevator 115, the shutter opening/closing mechanism 115s, and the like.

The CPU 121a is configured to read and execute the control program from the memory 121c and read the recipe from the memory 121c according to an input of an operation command or the like from the input/output device 122. The CPU 121a is configured to control the flow rate regulating operation of various kinds of gases by the MFCs 241a to 241j, the opening/closing operation of the valves 243a to 243j, the opening/closing operation of the APC valve 244, the pressure regulating operation performed by the APC valve 244 based on the pressure sensor 245, the actuating and stopping operation of the vacuum pump 246, the temperature regulating operation performed by the heater 207 based on the temperature sensor 263, the operation of rotating the boat 217 with the rotator 267 and adjusting a rotation speed of the boat 217, the operation of moving the boat 217 up or down by the boat elevator 115, the opening/closing operation of the shutter 219s by the shutter opening/closing mechanism 115s, and so on, according to contents of the read recipe.

The controller 121 may be constituted by installing, on the computer, the aforementioned program stored in an external memory 123. Examples of the external memory 123 may include a magnetic disk such as a HDD, an optical disc such as a CD, a magneto-optical disc such as a MO, a semiconductor memory such as a USB memory. The memory 121c or the external memory 123 is constituted as a computer-readable recording medium. Hereinafter, the memory 121c and the external memory 123 may be generally and simply referred to as a "recording medium." When the term "recording medium" is used herein, it may indicate a case of including the memory 121c, a case of including the external memory 123, or a case of including both the memory 121c and the external memory 123. Further, the program may be provided to the computer by using communication means or unit such as the Internet or a dedicated line, instead of using the external memory 123.

### (2) Substrate Processing Process

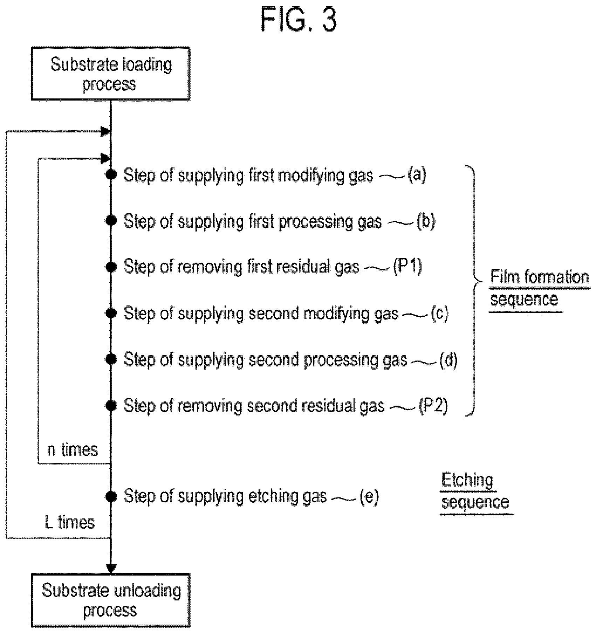

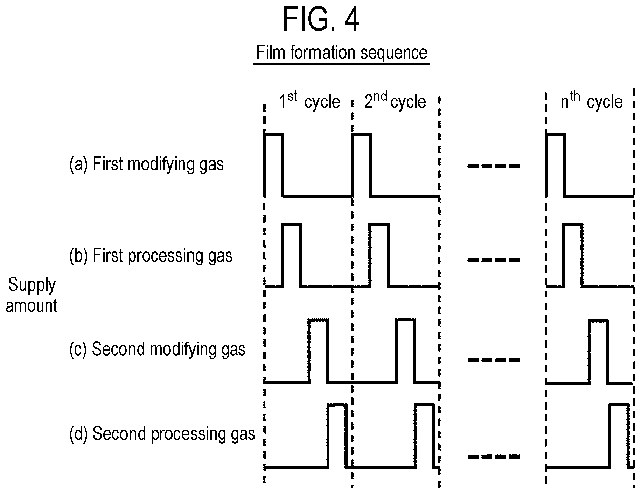

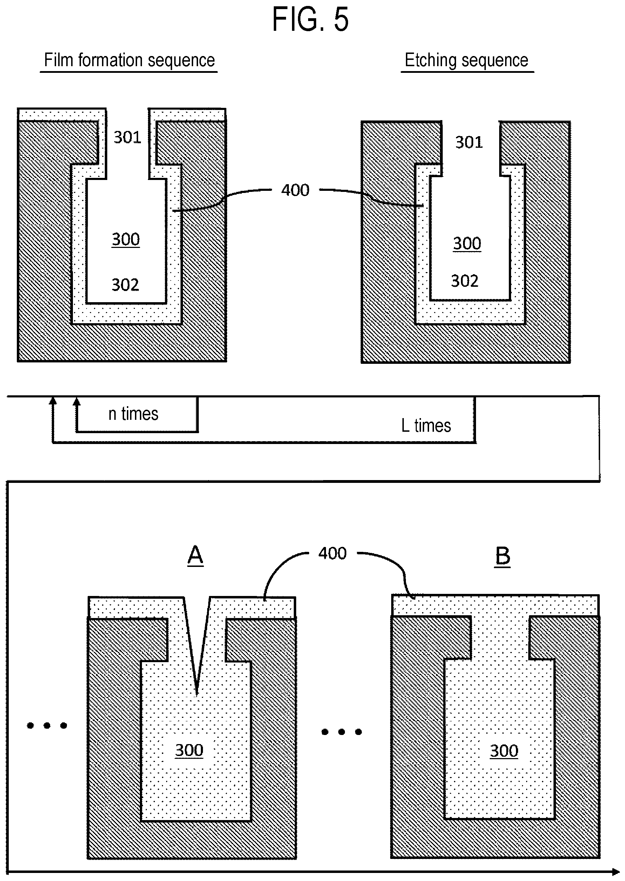

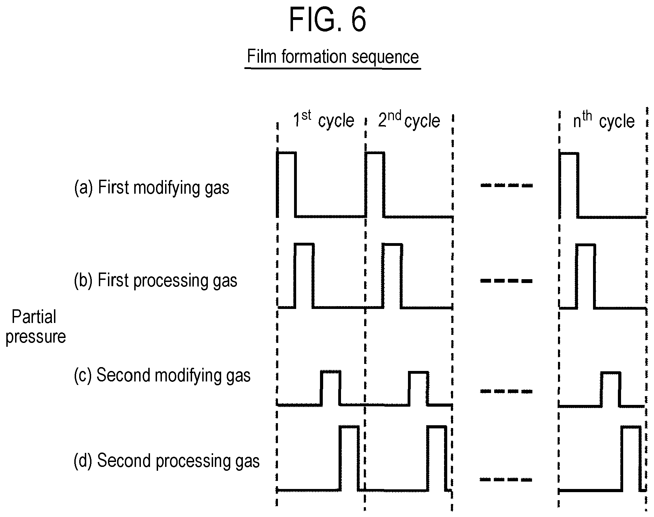

FIG. 3 is a diagram for explaining a substrate processing method according to some embodiments of the present disclosure. FIGS. 4 and 6 are diagrams showing film formation sequences according to some embodiments of the present disclosure. FIG. 5 is a diagram for explaining a progress of a method of processing a substrate.

As a process in a method of manufacturing a semiconductor device (a method of processing a substrate), an example of a process of forming a film on a substrate (wafer) including a trench (a groove, a recess, or a barrel-shaped recess) formed thereon will be described with reference to FIGS. 3 to 6. The process of forming the film is carried out in the process chamber 201 of the substrate processing apparatus shown in FIG. 1. In the following description, an operation of each component constituting the substrate processing apparatus is controlled by the controller 121 shown in FIG. 2.

A preferred film formation sequence (also simply referred to as a sequence) according to the present embodiment includes performing a cycle, on a wafer 200, a predetermined number of times, the cycle including sequentially performing:
(a) supplying a first modifying gas, which is an inorganic halogen element-containing gas:
(b) supplying a precursor gas;
(c) supplying a second modifying gas, which is an inorganic halogen element-containing gas; and
(d) supplying a reaction gas.

The term "sequentially" refers to "in an order of (a) → (b) → (c) → (d) as described."

In the present embodiment, the cycle is performed by using, for example, the following gases. The first modifying gas and the second modifying gas are inorganic halogen element-containing gases. For example, a halogen hydride gas is used. The precursor gas is a gas containing a metal element as a first element. The reaction gas is, for example, a N-containing gas.

Specifically, as shown in FIG. 4, the film formation sequence forms a film containing a first element (also simply referred to as a film) by performing a cycle of supplying a first modifying gas, a precursor gas containing the first element, a second modifying gas, and a reaction gas in a time-division manner a predetermined number of times (n times).

As shown in FIG. 5, on the surface of the substrate (wafer) 200, there are a portion where a gas that forms a thin film may easily reach and a portion where the gas may not easily reach. An example of the portion where the gas may easily reach is a top side 301 of a recess (or a barrel-shaped recess or a trench) 300 with a high aspect ratio. An example of the portion where the gas may not easily reach is a bottom side (a deep side) 302 of a recess 300 with a high aspect ratio.

As shown in FIG. 3, a method of processing a substrate includes the following steps (a), (b), (P1), (c), (d), and (P2) as a film formation sequence:
(a) step of supplying a first modifying gas (step of supplying a first reaction inhibition gas);
(b) step of supplying a precursor gas (supplying a halogen-based precursor gas);
(P1) step of removing a first residual gas;
(c) step of supplying a second modifying gas (step of supplying a second reaction inhibition gas);
(d) step of supplying a reaction gas (step of supplying a N-containing gas); and
(P2) step of removing a residual gas.
A cycle of performing (a), (b), (P1), (c), (d), and (P2) in this order as described is performed a predetermined number of times. For example, the predetermined number of times is n times (where n is an integer of 1 or more).

Then, as shown in FIG. 3, an etching step (e) of etching the formed film may be performed as an etching sequence, and thereafter, a cycle of performing the film formation sequence and the etching sequence is performed again a predetermined number of times to form a film. At this time, the predetermined number is L times, where L is an integer of 0 or more. Herein, when L = 0, it means that the etching step (e) is not performed. That is, in the method of processing the substrate shown in FIG. 3, a cycle of performing (a), (b), (P1), (c), (d), and (P2) in this order as described may be performed a predetermined number of times without performing (e).

FIG. 5 is a diagram explaining a progress of a method of processing a substrate. Herein, an example is explained in which a film 400 is filled in a barrel-shaped recess 300 formed on a surface of a substrate (wafer) 200. A top side 301 of the recess 300 is a portion where a gas may easily reach, and a bottom side 302 of the recess 300 is a portion where the gas may not easily reach.

In an initial cycle of film formation, a film formation sequence is performed n times to form a thin film 400 on an inner wall of the barrel-shaped recess 300. Then, an etching sequence is performed to remove the film 400 from the top side 301 of the recess 300 by etching. This widens an opening of the top side 301 of the recess 300, enabling the gas to easily reach an inside of the recess 300.

In a case where the cycle of performing the film formation sequence and the etching sequence is performed a plurality of times, as indicated by state A in FIG. 5, the inside of the recess 300 is gradually filled with the film 400. Finally, as indicated by state B, the inside of the recess 300 is completely filled with the film 400.

In the present disclosure, "performing a treatment (referred to as a process, a cycle, a step, etc.) a predetermined number of times" means performing the process once or multiple times, i.e., performing the process one or more times. FIG. 5 shows an example in which each process in the film formation sequence is performed n cycles, and an example in which each process in the film formation sequence and the etching sequence is performed L cycles. A value of n or a value of L is appropriately selected according to a film thickness for the film to be finally formed. In other words, the number of times each of the above-mentioned processes is performed is determined according to a target film thickness.

In the present disclosure, "time division" means division (separation) in time. For example, in the present disclosure, performing each process in a time-division manner means that each process is performed asynchronously, i.e., without synchronization. In other words, it means that each process is performed intermittently (in a pulsed manner). That is, it means that the process gases supplied in each process are supplied so as not to mix with each other. When each process is performed multiple times in a time-division manner, the process gases supplied in each process are supplied alternately so as not to mix with each other.

When the term "wafer" is used in the present disclosure, it may refer to "a wafer itself" or "a stacked body (an assembly) of a wafer and a certain layer, a certain film, or the like formed on a surface of the wafer (that is, the wafer may include the certain layer, the certain film, or the like formed on the surface of the wafer)." When the phrase "a surface of a wafer" is used in the present disclosure, it may refer to "a surface (an exposed surface) of a wafer itself" or "a surface of a certain layer, a certain film, or the like formed on a wafer (that is, an uppermost surface of a wafer as a stacked body)." When the term "substrate" is used in the present disclosure, it may be synonymous with the term "wafer."

Therefore, in the present disclosure, when it is stated that "a predetermined gas is supplied to a wafer", it may mean that "a predetermined gas is directly supplied to a surface (an exposed surface) of a wafer itself" or "a predetermined gas is supplied to a layer, a film, or the like formed on a wafer, i.e., to an outermost surface of a wafer as a laminated body". In addition, in the present disclosure, when it is stated that "a predetermined layer (or a predetermined film) is formed on a wafer," it may mean that "a predetermined layer (or a predetermined film) is directly formed on a surface (an exposed surface) of a wafer itself" or "a predetermined layer (or a predetermined film) is formed on a layer, a film, or the like formed on a wafer, i.e., on an outermost surface of a wafer as a laminated body".

In the present disclosure, a process temperature means a temperature of the wafer 200 or an inner temperature of the process chamber 201, and a process pressure means an internal pressure of the process chamber 201. Further, a process time means a time during which a process continues. The same applies to the following descriptions.

The substrate processing method shown in FIG. 3 will now be described in detail.

### (Substrate Loading Process)

In a substrate loading process, (wafer charging and boat loading) and (pressure regulation and temperature regulation) are carried out.

### (Wafer Charging and Boat Loading)

After the boat 217 is charged with a plurality of wafers 200 (wafer charging), the shutter 219s is moved by the shutter opening/closing mechanism 115s to open a lower end opening of the manifold 209 (shutter opening). Thereafter, as shown in FIG. 1, the boat 217 supporting the plurality of wafers 200 is lifted by the boat elevator 115 to be loaded into the process chamber 201 (boat loading). In this state, the seal cap 219 seals the lower end of the manifold 209 via the O-ring 220b.

### (Pressure Regulation and Temperature Regulation)

An inside of the process chamber 201, that is, a space where the wafers 200 are placed, is vacuum-exhausted (decompression-exhausted) by the vacuum pump 246 to reach a desired pressure (a degree of vacuum). At this time, the internal pressure of the process chamber 201 is measured by the pressure sensor 245, and the APC valve 244 is feedback-controlled based on the measured pressure information. Further, the wafers 200 in the process chamber 201 are heated by the heater 207 to a desired processing temperature. At this time, a state of supplying electric power to the heater 207 is feedback-controlled based on the temperature information detected by the temperature sensor 263 such that a temperature distribution inside the process chamber 201 becomes a desired temperature distribution. Further, rotation of the wafers 200 by the rotator 267 is started. The exhaust of the inside of the process chamber 201 and the heating and rotation of the wafers 200 are continuously performed at least until the processing on the wafers 200 is completed.

### (Film Formation Step)

The film formation step is then carried out. The film formation step includes: (a) a step of supplying a first modifying gas (a step of supplying a first reaction inhibition gas), (b) a step of supplying a precursor gas (supplying a halogen-based precursor gas), (P1) a step of removing a first residual gas, (c) a step of supplying a second modifying gas (a step of supplying a second reaction inhibition gas), (d) a step of supplying a reaction gas (a step of supplying a N-containing gas), and (P2) a step of removing a residual gas, which are described below. Herein, steps (a) to (P2) are performed a predetermined number of times. Further, in this example, after the steps (a) to (P2) are performed the predetermined number of times, an etching step (e) is performed.

### (a) Step of Supplying First Modifying Gas (Step of Supplying First Reaction Inhibition Gas)

First, the valve 243b is opened to allow the first modifying gas (a first inorganic halogen element-containing gas, or a first reaction inhibition gas) to flow through the gas supply pipe 232b. A flow rate of the first modifying gas flowing through the gas supply pipe 232b is regulated by the MFC 241b. The first modifying gas regulated in flow rate is supplied from the nozzle 249b into the process chamber 201 and exhausted from the exhaust pipe 231. At this time, the first modifying gas is supplied to the wafer 200. That is, the surface of the wafer 200 is exposed to the first modifying gas. At the same time, the valve 243g is opened to allow a N₂ gas to flow through the gas supply pipe 232g. A flow rate of the N₂ gas flowing through the gas supply pipe 232g is regulated by the MFC 241g. The N₂ gas regulated in flow rate is supplied into the process chamber 201 together with the first modifying gas, and is exhausted from the exhaust pipe 231.

At this time, as shown in FIG. 6, the film formation sequence may be performed under a condition that a partial pressure of the first modifying gas in the process chamber 201 in (a) (hereinafter, referred to as a partial pressure of the first modifying gas) is higher than a partial pressure of the second modifying gas in the process chamber 201 in (c) (hereinafter, referred to as the partial pressure of the second modifying gas), which is described below. Hereinafter, a case in which the partial pressure of the first modifying gas is higher than the partial pressure of the second modifying gas will be described by way of example.

Herein, the partial pressure of the first modifying gas and the partial pressure of the second modifying gas may be increased or decreased, for example, by at least one selected from the group of a ratio of amounts of the first modifying gas and the second modifying gas to an amount (e.g., a mass, a volume, a substance amount, or the like) of the entire gases present in the process chamber 201 (hereinafter, referred to as a concentration of the first modifying gas or a concentration of the second modifying gas), and the internal pressure of the process chamber 201 in (a) and (c) (hereinafter, referred to as a total pressure in (a) or a total pressure in (c)). Therefore, when the partial pressure of the first modifying gas is made higher than the partial pressure of the second modifying gas, specifically, a condition under which (a) and (c) are performed may be set so that at least one selected from the group of a condition under which the concentration of the first modifying gas is higher than the concentration of the second modifying gas and a condition under which the total pressure in (c) is higher than the total pressure in (a) is satisfied. More specifically, the condition under which (a) and (c) are performed may be set so that both conditions are satisfied.

The concentration of the first modifying gas may be changed, for example, by controlling a ratio of the flow rate of the first modifying gas supplied per unit time into the process chamber 201 to the flow rate of the inert gas supplied per unit time into the process chamber 201 in (a). Further, the total pressure in (a) may be changed, for example, by controlling a ratio of the flow rate of the gas supplied per unit time into the process chamber 201 to the flow rate of the gas exhausted per unit time from the inside of the process chamber 201 in (a).

Similarly, the concentration of the second modifying gas may be changed, for example, by controlling a ratio of the flow rate of the second modifying gas supplied per unit time into the process chamber 201 to the flow rate of the inert gas supplied per unit time into the process chamber 201 in (c). Further, the total pressure in (c) may be changed, for example, by controlling a ratio of the flow rate of the gas supplied per unit time into the process chamber 201 to the flow rate of the gas exhausted per unit time from the inside of the process chamber 201 in (c).

At this time, the vacuum pump 264 and the APC valve 244 are appropriately regulated to set the internal pressure of the process chamber 201 to, for example, a (predetermined) pressure in a range of 1 to 13,300 Pa, specifically a (predetermined) pressure in a range of 1 to 1,330 Pa, and more specifically a (predetermined) pressure in a range of 1 to 133 Pa. In a case where the internal pressure of the process chamber 201 is higher than 13,300 Pa, the first modifying gas may excessively react with (or may be excessively adsorbed on) the wafer 200, and may inhibit the adsorption of the precursor gas on the surface (including the trench) of the wafer 200 by a predetermined amount or more as described below. In a case where the pressure in the process chamber 201 is lower than 1 Pa, there is a possibility that an effect of inhibiting the adsorption of the precursor gas may not be sufficiently obtained by the first modifying gas.

A supply flow rate of the first modifying gas controlled by the MFC 241b is equal to or less than an amount to entirely cover the surface of the wafer 200, and is, for example, a (predetermined) flow rate within a range of 1 to 3,000 sccm, specifically a (predetermined) flow rate within a range of 10 to 1,000 sccm, and more specifically a (predetermined) flow rate within a range of 10 to 500 sccm. In a case where the supply flow rate of the first modifying gas is more than 3,000 sccm, the first modifying gas may significantly enter a bottom side of the trench, which may affect the film formation at the bottom side of the trench. In a case where the supply flow rate of the first modifying gas is less than 1 sccm, there is a possibility that it may be difficult for the first modifying gas to obtain the effect of inhibiting the adsorption of the precursor gas.

A supply flow rate of the inert gas controlled by the MFC 241g is, for example, a (predetermined) flow rate within a range of 1 to 20,000 sccm, specifically a (predetermined) flow rate within a range of 10 to 15,000 sccm, and more specifically a (predetermined) flow rate within a range of 100 to 10,000 sccm. In a case where the supply flow rate of the inert gas is more than 20,000 sccm, it may be difficult for the first modifying gas to obtain the effect of inhibiting the adsorption of the precursor gas. In a case where the supply flow rate of the inert gas is less than 1 sccm, removal of a residual gas described below may not be performed sufficiently.

A time to supply the first modifying gas to the wafer 200, i.e., a supply time of the gas (an irradiation time), is, for example, a (predetermined) time within a range of 0.01 to 120 seconds, specifically a (predetermined) time within a range of 0.1 to 60 seconds, and more specifically a (predetermined) time within a range of 1 to 10 seconds. In a case where the supply time of the gas is longer than 120 seconds, the first modifying gas may excessively react with (or may be excessively adsorbed on) the wafer 200, and may inhibit a reaction between the precursor gas and the surface of the wafer 200 by a predetermined amount or more. In a case where the supply time of the gas is shorter than 1 second, there is a possibility that the effect of inhibiting the adsorption of the precursor gas may not be sufficiently obtained by the first modifying gas.

A temperature of the heater 207 is set so that the temperature of the wafer 200 is, for example, a (predetermined) temperature within a range of 200 to 600 degrees C, specifically a (predetermined) temperature within a range of 200 to 550 degrees C, and more specifically a (predetermined) temperature within a range of 300 to 500 degrees C. This temperature is preferably set to the same temperature as that in the next (b) step of supplying the precursor gas.

### (b) Step of Supplying Precursor Gas (Supply of Halogen-Based Precursor Gas)

Then, the valve 243b is closed to stop the supply of the first modifying gas. Further, the valve 243c is closed to stop the supply of the inert gas.

Subsequently, the valve 243a is opened to allow a precursor gas containing a first element (e.g., a gas containing a halogen element) to flow through the gas supply pipe 232a. A flow rate of the precursor gas flowing through the gas supply pipe 232a is regulated by the MFC 241a. The precursor gas regulated in flow rate is supplied from the nozzle 249a into the process chamber 201 and exhausted from the exhaust pipe 231. At this time, the precursor gas is supplied to the wafer 200. That is, the surface (including the trench) of the wafer 200 is exposed to the precursor gas. At the same time, the valve 24f is opened to allow an inert gas such as a N₂ gas to flow through the gas supply pipe 232f. The flow rate of the N₂ gas flowing through the gas supply pipe 232f is regulated by the MFC 241f. The N₂ gas regulated in flow rate is supplied into the process chamber 201 together with the precursor gas and exhausted from the exhaust port 231a.

In (b), the precursor gas is inhibited from being adsorbed on a portion where the first modifying gas is adsorbed in (a), and is adsorbed on a portion where the first modifying gas is not adsorbed. That is, in (b), the precursor gas is supplied to the wafer 200, and the precursor gas is preferentially adsorbed on a region which is not modified by the first modifying gas.

At this time, the vacuum pump 264 and the APC valve 244 are appropriately regulated to set the internal pressure of the process chamber 201 to, for example, a (predetermined) pressure within a range of 1 to 70,000 Pa, specifically a (predetermined) pressure within a range of 1 to 1,333 Pa, and more specifically a (predetermined) pressure within a range of 20 to 50 Pa. In a case where the internal pressure of the process chamber 201 is higher than 70,000 Pa, removal of the residual gas described below may not be performed sufficiently. In a case where the internal pressure of the process chamber 201 is lower than 0.01 Pa, a reaction rate between the precursor gas and the surface of the wafer 200 may not be obtained sufficiently.

The supply flow rate of the precursor gas controlled by the MFC 241a is set to a flow rate sufficient for the precursor gas to entirely cover the surface of the wafer 200 (including an inner surface of the trench), and is set to, for example, a (predetermined) flow rate within a range of 1 to 10,000 sccm, specifically a (predetermined) flow rate within a range of 10 to 5,000 sccm, and more specifically a (predetermined) flow rate within a range of 100 to 3,000 sccm. In a case where the supply flow rate of the precursor gas is more than 10,000 sccm, a large amount of impurities such as a halogen element and the like may be incorporated into the film, and removal of the residual gas, which is described below, may not be performed sufficiently. In a case where the supply flow rate of the precursor gas is less than 1 sccm, the reaction rate between the precursor gas and the surface of the wafer 200 may not be obtained sufficiently.

A supply flow rate of the N₂ gas controlled by the MFC 241f is, for example, a (predetermined) flow rate within a range of 1 to 20,000 sccm, specifically a (predetermined) flow rate within a range of 500 to 15,000 sccm, and more specifically a (predetermined) flow rate within a range of 600 to 800 sccm. In a case where the supply flow rate of the N₂ gas is more than 20,000 sccm, the reaction rate between the precursor gas and the surface of the wafer 200 may not be obtained sufficiently. In a case where the supply flow rate of the N₂ gas is less than 1 sccm, removal of the residual gas described below may not be performed sufficiently.

A time to supply the precursor gas to the wafer 200, i.e., a supply time of the precursor gas (an irradiation time), is, for example, a (predetermined) time within a range of 0.1 to 500 seconds, specifically a (predetermined) time within a range of 1 to 300 seconds, and more specifically a (predetermined) time within a range of 3 to 200 seconds. In a case where the supply time of the precursor gas is longer than 500 seconds, a large amount of the precursor gas may be adsorbed, which may deteriorate uniformity of a film thickness. In a case where the supply time of the precursor gas is shorter than 0.1 seconds, the reaction between the precursor gas and the surface of the wafer 200 may not occur sufficiently.

The temperature of the heater 207 is set so that the temperature of the wafer 200 is, for example, a (predetermined) temperature within a range of 200 to 600 degrees C, specifically a (predetermined) temperature within a range of 200 to 550 degrees C, and more specifically a (predetermined) temperature within a range of 300 to 500 degrees C. In a case where the temperature of the heater 207 is higher than 600 degrees C, thermal decomposition of the precursor gas is promoted, which may deteriorate the uniformity of the film thickness or increase in resistivity due to introduction of a large amount of impurities. On the other hand, in a case where the temperature of the heater 207 is lower than 200 degrees C, reactivity with the surface of the wafer 200 is reduced, which may make film formation difficult.

The gases flowing in the process chamber 201 are the precursor gas and the N₂ gas, and a first element-containing layer is formed on the wafer 200 (a base film on the surface of the wafer) by supplying the precursor gas.

The first element-containing layer may be a first element layer constituted by the first element, a first element layer containing an element other than the first element, such as a halogen element or the like, an adsorption layer of molecules of the precursor gas (hereinafter simply referred to as an adsorption layer of precursor molecules), or the entirety of them. The first element layer containing an element other than the first element is a general term including a continuous layer which is constituted by the first element and contains an element other than the first element, a discontinuous layer, and a first element-containing film which is formed by overlapping the continuous layer and the discontinuous layer and contains an element other than the first element. A continuous layer constituted by the first element and containing an element other than the first element may also be called a first element-containing film containing an element other than the first element. The first element constituting the first element layer containing an element other than the first element includes a first element whose bond with the element other than the first element is completely broken, as well as a first element whose bond with the element other than the first element is not completely broken.

The adsorption layer of the precursor molecules includes a discontinuous adsorption layer, as well as a continuous adsorption layer constituted by the molecules of the precursor gas. That is, the adsorption layer of the precursor molecules includes an adsorption layer constituted by the molecules of the precursor gas with a thickness of one molecular layer or less than one molecular layer. The molecules of the precursor gas constituting the adsorption layer of the precursor molecules also include a molecule where a bond between the first element and an element other than the first element is partially broken. That is, the adsorption layer of the precursor molecules may be a physical adsorption layer of the molecules of the precursor gas, a chemical adsorption layer of the molecules of the precursor gas, or both.

As used herein, a layer with a thickness less than one atomic layer means an atomic layer formed discontinuously, and a layer with a thickness of one atomic layer means an atomic layer formed continuously. A layer with a thickness less than one molecular layer means a molecular layer formed discontinuously, and a layer with a thickness of one molecular layer means a molecular layer formed continuously. The first element-containing layer containing an element other than the first element may include both a first element layer containing an element other than the first element and an adsorption layer of precursor molecules. However, as described above, the first element-containing layer containing an element other than the first element will be expressed by using expressions such as "one atomic layer," "several atomic layers," and the like.

Under a condition in which the precursor gas is autolyzed (thermally decomposed), a first element layer is formed by depositing a first element on the wafer 200. Under a condition in which the precursor gas is not autolyzed (thermally decomposed), the molecules of the precursor gas are adsorbed on the wafer 200 to form an adsorption layer of the precursor molecules. Forming the first element layer on the wafer 200 is better than forming the adsorption layer of the precursor molecules on the wafer 200 in that the former is capable of increasing a deposition rate.

**In** a case where a thickness of a first element-containing layer (hereinafter sometimes referred to as a first layer) formed in one (b) step of supplying a precursor gas exceeds several atomic layers, a modifying effect in (d) step of supplying a reaction gas (step of supplying a N-containing gas) described below will not reach the entire first layer. In addition, a minimum value of the thickness of the first layer is less than one atomic layer. Therefore, the thickness of the first layer may be from a thickness less than one atomic layer to a thickness of about several atomic layers. By making the thickness of the first layer be a thickness of one atomic layer or less, that is, a thickness of one atomic layer or a thickness less than one atomic layer, an efficiency of reaction in (d) step of supplying a reaction gas described below may be relatively increased, and a time for reaction in (d) step of supplying the reaction gas may be shortened. A time for formation of the first layer in (b) step of supplying the precursor gas may also be shortened. As a result, a processing time per cycle may be shortened, and a total processing time may also be shortened. That is, it is also possible to increase a deposition rate. In addition, by making the thickness of the first layer be a thickness of one atomic layer or less, it is also possible to improve a controllability of film thickness uniformity.

### (P1) Step of Removing First Residual Gas

Then, the valve 243a is closed to stop the supply of the precursor gas. At this time, the APC valve 244 of the exhaust pipe 231 is left open, and the inside of the process chamber 201 is vacuum-exhausted by the vacuum pump 264 such that the first modifying gas unreacted or acted as a reaction inhibition gas and reaction by-products, which remain in the process chamber 201, are removed from the process chamber 201. At this time, the gas and the like remaining in the process chamber 201 may not be completely removed, as in (b) step of supplying the precursor gas.

### (c) Step of Supplying Second Modifying Gas (Step of Supplying Second Reaction Inhibition Gas)

Next, the valve 243d is opened to allow a second modifying gas to flow through the gas supply pipe 232d. A flow rate of the second modifying gas flowing through the gas supply pipe 232d is regulated by the MFC 241d. The second modifying gas regulated in flow rate is supplied from the nozzle 249d into the process chamber 201 and exhausted from the exhaust pipe 231. At this time, the second modifying gas is supplied to the wafer 200. That is, the surface of the wafer 200 is exposed to the second modifying gas. At the same time, the valve 243i is opened to allow a N₂ gas to flow through the gas supply pipe 232i. A flow rate of the N₂ gas flowing through the gas supply pipe 232i is regulated by the MFC 241i. The N₂ gas regulated in flow rate is supplied into the process chamber 201 together with the second modifying gas and exhausted from the exhaust pipe 231.

By appropriately regulating the vacuum pump 264 and the APC valve 244, the internal pressure of the process chamber 201 is set to, for example, a (predetermined) pressure in a range of 1 to 13,300 Pa, specifically a (predetermined) pressure in a range of 1 to 1,330 Pa, and more specifically a (predetermined) pressure in a range of 1 to 133 Pa. In a case where the internal pressure of the process chamber 201 is higher than 13,300 Pa, the second modifying gas may excessively react with (or may be excessively adsorbed on) the wafer 200, and a reaction between the first element-containing layer and the reaction gas, which is described below, may be inhibited by a predetermined amount or more. In a case where the internal pressure of the process chamber 201 is lower than 1 Pa, a reaction rate between the second modifying gas and the first element-containing layer may not be sufficiently obtained.

A supply flow rate of the second modifying gas controlled by the MFC 241d is equal to or less than a flow rate to entirely cover the surface of the wafer 200, and is, for example, a (predetermined) flow rate within a range of 1 to 3,000 sccm, specifically a (predetermined) flow rate within a range of 10 to 1,000 sccm, and more specifically a (predetermined) flow rate within a range of 10 to 500 sccm. In a case where the supply flow rate of the second modifying gas is more than 3,000 sccm, the second modifying gas may significantly enters the bottom side of the trench, affecting the film formation at the bottom side of the trench. In a case where the supply flow rate of the second modifying gas is less than 1 sccm, the second modifying gas may not sufficiently inhibit the reaction between the first element-containing layer and the reaction gas.

A supply flow rate of the N₂ gas controlled by the MFC 241g is, for example, a (predetermined) flow rate within a range of 1 to 20,000 sccm, specifically a (predetermined) flow rate within a range of 10 to 15,000 sccm, and more specifically a (predetermined) flow rate within a range of 100 to 10,000 sccm. In a case where the supply flow rate of the N₂ gas is more than 20,000 sccm, the reaction rate between the second modifying gas and the first element-containing layer may not be obtained sufficiently. In a case where the supply flow rate of the N₂ gas is less than 1 sccm, removal of the residual gas, which is described below, may not be performed sufficiently.

A time to supply the second modifying gas to the wafer 200, i.e., a supply time of the gas (an irradiation time), is, for example, a (predetermined) time within a range of 0.01 to 120 seconds, specifically a (predetermined) time within a range of 0.1 to 60 seconds, and more specifically a (predetermined) time within a range of 1 to 10 seconds. In a case where the supply time of the gas is longer than 120 seconds, the second modifying gas may excessively react with (or may be excessively adsorbed on) the wafer 200, and may inhibit the reaction between the first element-containing layer and the reaction gas by a predetermined amount or more. In a case where the supply time of the gas is shorter than 1 second, the reaction between the first element-containing layer and the reaction gas may not be inhibited sufficiently.

The temperature of the heater 207 is set so that the temperature of the wafer 200 is, for example, a (predetermined) temperature within a range of 200 to 600 degrees C, specifically a (predetermined) temperature within a range of 200 to 550 degrees C, and more specifically a (predetermined) temperature within a range of 300 to 500 degrees C. This temperature may be set to the same temperature as that in the next (b) step of supplying the precursor gas.

### (d) Step of Supplying Reaction Gas

Next, the valve 243c is opened to allow a reaction gas to flow through the gas supply pipe 232c. The reaction gas is, for example, a N-containing gas or a reducing gas. A flow rate of the reaction gas flowing through the gas supply pipe 232c is regulated by the MFC 241c. The reaction gas regulated in flow rate is supplied from the nozzle 249c into the process chamber 201 and exhausted from the exhaust pipe 231. At the same time, the valve 243h is opened to allow a N₂ gas to flow through the gas supply pipe 232h. A flow rate of the N₂ gas flowing through the gas supply pipe 232h is regulated by the MFC 241h. The N₂ gas is supplied into the process chamber 201 together with the reaction gas and exhausted from the exhaust pipe 231.

When allowing the reaction gas to flow, the pressure regulator 244 is appropriately regulated to set the internal pressure of the process chamber 201 to, for example, a (predetermined) pressure within a range of 0.01 to 13,300 Pa, specifically a (predetermined) pressure within a range of 1 to 1,330 Pa, and more specifically a (predetermined) pressure within a range of 10 to 133 Pa. In a case where the internal pressure of the process chamber 201 is higher than 13,300 Pa, removal of the residual gas, which is described below, may not be performed sufficiently. In a case where the internal pressure of the process chamber 201 is lower than 0.01 Pa, a sufficient deposition rate may not be obtained.

A supply flow rate of the reaction gas controlled by the MFC 241c is set to a flow rate sufficient to entirely cover the surface of the wafer 200, and is set to, for example, a (predetermined) flow rate within a range of 10 to 50,000 sccm, specifically a (predetermined) flow rate within a range of 300 to 10,000 sccm, and more specifically a (predetermined) flow rate within a range of 1,000 to 8,000 sccm. As the supply flow rate of the reaction gas is increased, introduction of impurities originating from the precursor gas into the film may be decreased, which is therefore desirable. In a case where the supply flow rate of the reaction gas is more than 50,000 sccm, the residual gas may not be sufficiently removed in the step of removing the residual gas, which is described below. In a case where the supply flow rate of the reaction gas is less than 10 sccm, the reaction gas may not react with the first element-containing layer sufficiently.

A supply flow rate of the N₂ gas controlled by the MFC 241h is, for example, a (predetermined) flow rate within a range of 10 to 20,000 sccm, specifically a (predetermined) flow rate within a range of 400 to 15,000 sccm, and more specifically a (predetermined) flow rate within a range of 400 to 7,500 sccm. In a case where the supply flow rate of the N₂ gas is more than 20,000 sccm, the deposition rate may be too low. In a case where the supply flow rate of the N₂ gas is less than 10 sccm, the reaction gas may not be sufficiently supplied to the wafer 200.

A time to supply the reaction gas to the wafer 200, i.e., a supply time of the gas (an irradiation time), is, for example, a (predetermined) time within a range of 0.001 to 300 seconds, specifically a (predetermined) time within a range of 0.1 to 200 seconds, and more specifically a (predetermined) time within a range of 5 to 60 seconds. As the supply time of the gas is increased, introduction of impurities originating from the precursor gas into the film may be decreased, which is therefore desirable. However, in a case where the supply time of the gas is longer than 300 seconds, a throughput may deteriorate. In a case where the supply time of the gas is shorter than 0.001 seconds, a reaction rate of the reaction with the first element-containing layer may not be obtained sufficiently.

The temperature of the heater 207 is set to the same temperature as that in the step of supplying the precursor gas.

At this time, the gases flowing through the process chamber 201 are the reaction gas and the N₂ gas. The reaction gas undergoes a substitution reaction with at least a part of a portion of the first element-containing layer formed on the wafer 200 in the step of supplying the precursor gas that does not react with the second modifying gas in the step of supplying the second modifying gas. By the substitution reaction, a layer containing the first element and an element contained in the reaction gas is formed on the wafer 200. The first element and the element contained in the reaction gas may include other elements originating from the first element-containing layer that did not undergo the substitution reaction and the respective precursors contained in the first element-containing layer.

### (P2) Step of Removing Residual Gas

After forming the layer containing the first element and the element contained in the reaction gas, the valve 243e is closed to stop the supply of the reaction gas. At this time, the APC valve 244 of the exhaust pipe 231 is left open, and the inside of the process chamber 201 is vacuum-exhausted by the vacuum pump 264 such that unreacted reaction gas, reaction by-products, and the reaction gas which contributed to the formation of the layer containing the first element and the element contained in the reaction gas, which remain in the process chamber 201, are removed from the process chamber 201.

### (Performing a Predetermined Number of Times)

The processes of above-mentioned film formation sequence (including (a) step of supplying the first modifying gas, (b) step of supplying the precursor gas, (P1) step of removing the first residual gas, (c) step of supplying the second modifying gas, (d) step of supplying the reaction gas, and (P2) step of removing the residual gas) constitute one cycle, and these processes are performed n cycles (where n is an integer of 1 or more). Thus, a film with a predetermined thickness (e.g., 0.1 to 10 nm) is formed on the wafer 200. The above-mentioned cycle may be performed multiple times.

When the cycle is performed multiple times, in each step of the cycle at least on and after the second time, a phrase "a gas is supplied to a wafer 200" means that "a predetermined gas is supplied to a layer formed on a wafer 200, i.e., to the outermost surface of a wafer 200 as a laminated body," and a phrase "a predetermined layer is formed on a wafer 200" means that "a predetermined layer is formed on a layer formed on a wafer 200, i.e., on the outermost surface of a wafer 200 as a laminated body."

### (e) Etching Step (Etching Process)

Then, the valve 243e is opened to allow an etching gas to flow through the gas supply pipe 232e. A flow rate of the etching gas flowing through the gas supply pipe 232e is regulated by the MFC 241e. The etching gas regulated in flow rate is supplied from the nozzle 249e into the process chamber 201 and exhausted from the exhaust pipe 231. At this time, the etching gas is supplied to the wafer 200. As a result, a part of the film formed on the surface of the wafer 200 is etched. When the etching step is completed, the valve 243e is closed to stop the supply of the etching gas.

By appropriately regulating the vacuum pump 264 and the APC valve 244, the internal pressure of the process chamber 201 is set to, for example, a (predetermined) pressure within a range of 1 to 13,300 Pa, specifically within a range of 1 to 1,330 Pa, and more specifically within a range of 1 to 133 Pa.

A supply flow rate of the etching gas controlled by the MFC 241e is equal to or less than a flow rate to entirely cover the surface of the wafer 200, and is set to, for example, a (predetermined) flow rate within a range of 1 to 3,000 sccm, specifically a (predetermined) flow rate within a range of 10 to 1,000 sccm, and more specifically a (predetermined) flow rate within a range of 10 to 500 sccm.

A supply flow rate of the N₂ gas controlled by the MFC 241h is, for example, a (predetermined) flow rate within a range of 1 to 40,000 sccm, specifically a (predetermined) flow rate within a range of 10 to 3,000 sccm, and more specifically a (predetermined) flow rate within a range of 100 to 20,000 sccm.

A time to supply the etching gas to the wafer 200, i.e., a supply time of the gas (an irradiation time), is, for example, a (predetermined) time within a range of 0.1 to 300 seconds, specifically a (predetermined) time within a range of 1 to 200 seconds, and more specifically a (predetermined) time within a range of 5 to 100 seconds.

After the above-mentioned (e) etching step, while the APC valve 244 of the exhaust pipe 231 are left open, and the inside of the process chamber 201 may be vacuum-exhausted by the vacuum pump 264. In addition, a step in which a cycle of sequentially performing the above-mentioned (e) etching step and the vacuum exhaustion of the inside of the process chamber 201 performed after the above-mentioned (e) etching step is performed a predetermined number of times (one or more times) may be the (e) etching step (etching process).

### (Performing a Predetermined Number of Times)

The above-mentioned processes of "n times of film formation sequence and etching sequence ((e) etching step)" constitute one cycle, and these processes are performed L cycles (where L is an integer of 0 or more). Thus, a film with a predetermined thickness (e.g., 0.1 to 10 nm) is formed on the wafer 200. Further, this cycle may be performed multiple times.

When a cycle of performing a film formation sequence and an etching sequence is performed multiple times, an inside of the recess 300 is gradually filled with the film 400, as indicated by state A in FIG. 5. Finally, the inside of the recess 300 is completely filled with the film 400, as indicated by state B.

### (Substrate Unloading Process)

### (After-Purge Step/Step of Returning to Atmospheric Pressure)

The valves 243f to 243j are opened, and the N₂ gas is supplied into the process chamber 201 from each of the gas supply pipes 232f to 232j and exhausted from the exhaust pipe 231. The N₂ gas acts as a purge gas. Thus, the inside of the process chamber 201 is purged with an inert gas, and the gas and the by-products remaining in the process chamber 201 are removed from the inside of the process chamber 201 (after-purge). Thereafter, an internal atmosphere of the process chamber 201 is substituted with the inert gas (inert gas substitution), and the internal pressure of the process chamber 201 is returned to the atmospheric pressure (returning to atmospheric pressure).

Thereafter, the seal cap 219 is lowered by the boat elevator 115 to open a lower end of an outer tube 203. Then, the processed wafers 200 supported by the boat 217 are unloaded from the lower end to an outside of the outer tube 203 (boat unloading). Then, the processed wafers 200 are discharged from the boat 217 (wafer discharging).

According to the embodiments of the present disclosure, one or more of the following effects may be obtained.

As shown in FIG. 3, the cycle is performed a predetermined number of times in the order of (a)→(b)→(c)→(d). In (a) and (c), the first and second modifying gases preferentially modify the portion where the gas may easily reach (the top side 301 of the recess 300, and the like) and do not easily modify the portion where the gas may not easily reach (the bottom side 302 of the recess 300, and the like). Therefore, in (b), the adsorption of the precursor gas on the portion where the gas may easily reach is inhibited, and the adsorption of the precursor gas on the portion where the gas may not easily reach is not inhibited. In addition, in (d), the reaction between the reaction gas and the precursor gas in the portion where the gas may easily reach is inhibited, and the reaction between the reaction gas and the precursor gas in the portion where the gas may not easily reach is not easily inhibited. Therefore, a film with a uniform thickness may be formed from the portion where the gas may easily reach to the portion where the gas may not easily reach (the bottom side 302 of the recess 300, and the like). It is difficult for halogen elements to remain as impurities in the film, which may suppress deterioration of electrical characteristics.

A region where the second modifying gas is adsorbed on the substrate 200 in (c) may be configured to be smaller than a region where the first modifying gas is adsorbed on the substrate in (a). For example, the region where the second modifying gas modifies the bottom side 302 of the recess 300 in (c) may be configured to be smaller than the region where the first modifying gas modifies the bottom side 302 of the recess 300 in (a). As a result, in (d), the region where the reaction between the precursor gas and the reaction gas is not inhibited is increased in the portion where the gas may not easily reach. Accordingly, an amount of an unreacted precursor gas in the portion where the gas may not easily reach is reduced, and deterioration of electrical characteristics of the film may be suppressed. Therefore, the increase in film thickness (film growth) in the portion where the gas may easily reach is suppressed, and step coverage is improved or occurrence of voids is suppressed. In addition, since consumption of the reaction gas in the portion where the gas may easily reach is reduced, the reaction gas may easily reach the bottom side. Therefore, the amount of the unreacted precursor gas in the portion where the gas may easily reach is reduced.

An amount of the second modifying gas adsorbed on the portion where the gas may not easily reach (e.g., the bottom side 302 of the recess 300) in (c) may be set to be less than an amount of the first modifying gas adsorbed on the portion where the gas may not easily reach in (a). Thus, in (d), it is difficult for the reaction between the precursor gas and the reaction gas to be inhibited in the portion where the gas may not easily reach. Therefore, since it is difficult for the reaction between the precursor gas and the reaction gas to be inhibited in the portion where the gas may not easily reach, the step coverage is improved or the occurrence of voids is suppressed. In addition, since the amount of the unreacted precursor gas in the portion where the gas may not easily reach is reduced, the impurities in the film may be reduced to improve the electrical characteristics of the film.

An amount of the second modifying gas adsorbed on the portion where the gas may easily reach (e.g., the top side 301 of the recess 300) in (c) may be set to be greater than an amount of the second modifying gas adsorbed on the portion where the gas may easily reach in (a). Thus, in (d), it is easy for the reaction between the precursor gas and the reaction gas in the portion where the gas may easily reach to be inhibited. Thus, film growth in the portion where the gas may easily reach is suppressed, and the step coverage is improved or the occurrence of voids is suppressed. In addition, since consumption of the reaction gas in the portion where the gas may easily reach is reduced, the gas may easily reach the portion where the gas may not easily reach. Therefore, since the amount of the unreacted precursor gas in the portion where the gas may not easily reach is reduced, the impurities in the film are reduced to improve the electrical characteristics of the film.

As shown in FIG. 6, a partial pressure of the second modifying gas in a space (process chamber 201) in which the substrate 200 exists in (c) is set to be lower than a partial pressure of the first modifying gas in the space (process chamber 201) in (a). When the partial pressure of the gas is lowered, likelihood of collision of gas molecules is more greatly reduced in the portion where the gas may not easily reach (e.g., the bottom side 302 of the recess 300) than in the portion where the gas may easily reach (e.g., the top side 301 of the recess 300). Therefore, in the portion where the gas may not easily reach, an adsorption amount of the second modifying gas may be made smaller than that of the first modifying gas. Further, in the portion where the gas may easily reach, an adsorption amount of the second modifying gas may be made larger than that of the first modifying gas. As a result, it may be difficult for the reaction between the precursor gas and the reaction gas to be inhibited in the portion where the gas may not easily reach.

The etching sequence proceed more easily in the portion where the etching gas may easily reach (e.g., the top side 301 of the recess 300) than in the portion where the etching gas may not easily reach (e.g., the bottom side 302 of the recess 300). Therefore, the film thickness may be reduced in the portion where it is easy for film growth to occur, i.e., the portion where it is easy for the gas to reach. As a result, the step coverage is improved or the occurrence of voids is suppressed.

The precursor gas may be a gas containing a first element and a halogen element, and the reaction gas may be a reducing gas. By using the gas containing the halogen element, which is unlikely to remain as an impurity in the film, as the precursor gas, an increase in electrical resistance of a metal film is suppressed. In addition, by using a reducing gas as the reaction gas, oxidation of the metal film may be suppressed.

### (Modifications)

Next, several modifications will be described. Each modification provides effects described below, in addition to the same effects as the above-mentioned embodiments.

### (First Modification)

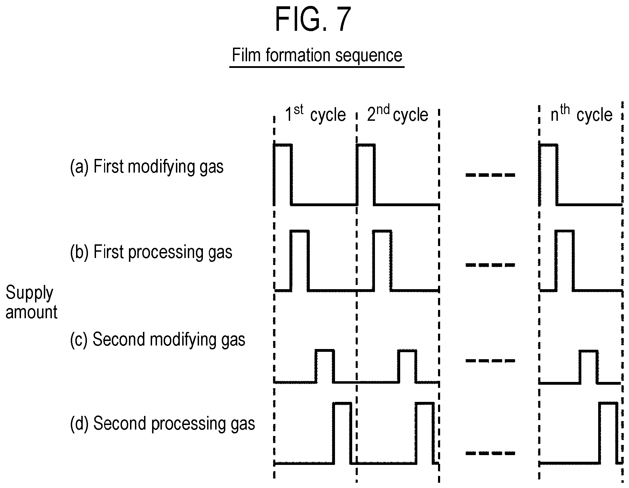

FIG. 7 is a diagram showing a film formation sequence according to a first modification. As shown in FIG. 7, in the first modification, a flow rate per unit time of the second modifying gas in (c) is smaller than a flow rate per unit time of the first modifying gas in (a). In this way, it is possible to create conditions in which the partial pressure of the first modifying gas in (a) is higher than the partial pressure of the second modifying gas in (c).

### (Second Modification)

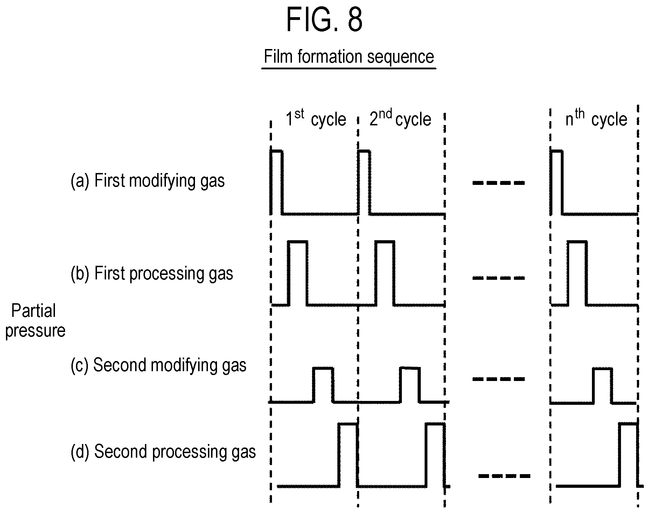

FIG. 8 is a diagram showing a film formation sequence according to a second modification. As shown in FIG. 8, in the second modification, in a state in which the partial pressure of the second modifying gas is lower than the partial pressure of the first modifying gas, a supply time of the second modifying gas in (c) is made longer than a supply time of the first modifying gas in (a). This makes it possible to promote the adsorption of the second modifying gas on the top side 301 of the recess 300 while minimizing the adsorption of the second modifying gas on the bottom side 302 of the recess 300. Accordingly, the reaction gas may easily reach the bottom side 302, and the amount of the unreacted precursor gas is reduced. In addition, the step coverage of the film to be formed is improved, and the occurrence of voids may be suppressed.

### (Third Modification)

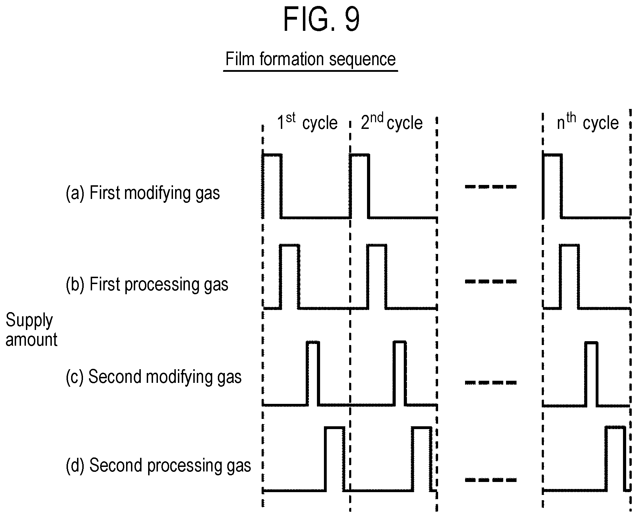

FIG. 9 is a diagram showing a film formation sequence according to a third modification. As shown in FIG. 9, in the third modification, a supply time of the second modifying gas in (c) may be shorter than a supply time of the first modifying gas in (a). In this case, the adsorption amount of the second modifying gas is more greatly reduced in the portion where the gas may easily reach than in the portion where the gas may not easily reach. As a result, the reaction gas may easily reach the portion where the gas may not easily reach, and the amount of the unreacted precursor gas is reduced. In addition, the step coverage of the film to be formed may be improved to suppress the occurrence of voids. This is also true when the partial pressure of the first modifying gas is lower than the partial pressure of the second modifying gas as in the embodiments, and is also true when the partial pressure of the first modifying gas is higher than the partial pressure of the second modifying gas. In addition, in a case where the partial pressure of the first modifying gas is higher than the partial pressure of the second modifying gas, by setting the supply time of the second modifying gas to be shorter than the supply time of the first modifying gas, it possible to reduce the amount of the unreacted precursor gas and improve the step coverage.

### (Fourth Modification)

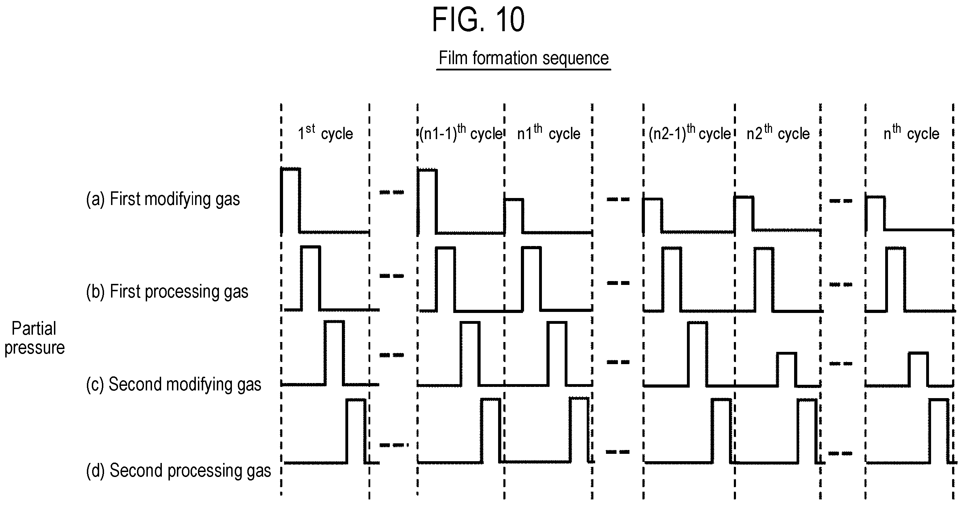

FIG. 10 is a diagram showing a film formation sequence according to a fourth modification. In the fourth modification, as shown in FIG. 10, in a film formation cycle on and after an n1-th time (where n1 is an integer of 2 or more and n or less, i.e., 2 ≦ n1 ≦ n), the partial pressure of the first modifying gas in the space (process chamber 201) in (a) is made to be lower than that in the film formation cycle on and before an (n1-1)-th time. Instead of reducing the partial pressure of the first modifying gas, (a) may not be performed. As the cycle proceeds, the recess 300 becomes shallower, which makes it possible to form a void-free film without reducing an adsorption amount of the first modifying gas or without causing the first modifying gas to be adsorbed. Accordingly, since suppression of adsorption of the precursor gas by the first modifying gas is reduced by reducing the partial pressure of the first modifying gas or not performing (a), the productivity may be increased.

Similarly, in the film formation cycle on and after an n2-th time (where n2 is an integer of 2 or more and n or less, i.e., 2 ≦ n2 ≦ n), the partial pressure of the second modifying gas in the space (process chamber 201) in (c) may be made to be lower than that in the film formation cycle on and before an (n2-1)-th time, or (c) may not be performed.

In FIG. 10, a case where n2 is a number larger than n1 (n1 < n2) is shown as an example, but the fourth modification is not limited thereto. For example, the film formation sequence according to the fourth modification may be performed by setting n1 to be a number larger than n2 (n2 < n1). Further, for example, the film formation sequence according to the fourth modification may be performed by setting n1 and n2 to be an equal number (n1 = n2). When n2 is set to the number greater than n1 (n1 < n2), it is more difficult to suppress the reaction between the reaction gas and the precursor gas by the second modifying gas than to suppress the adsorption of the precursor gas by the first modifying gas, making it possible to reduce the unreacted precursor gas, which is desirable.

### (Fifth Modification)

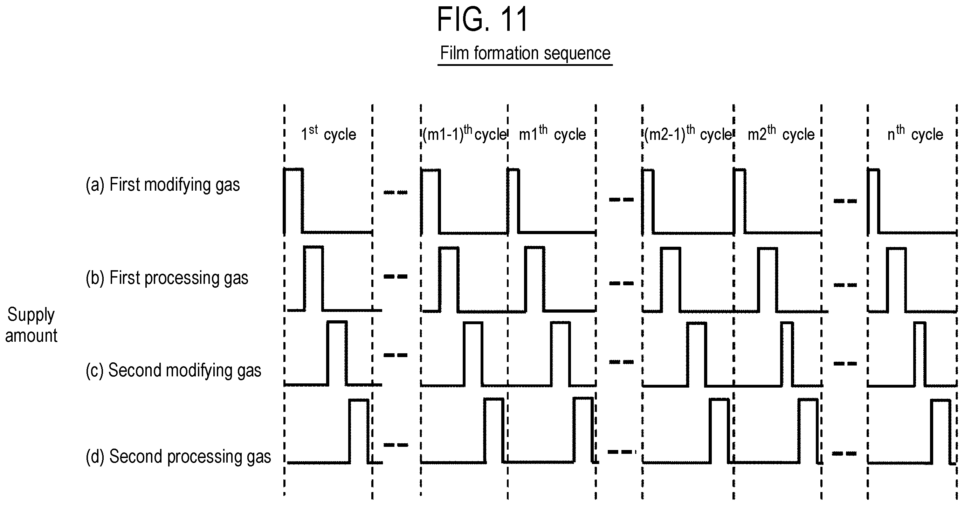

FIG. 11 is a diagram showing a film formation sequence according to a fifth modification. In the fifth modification, as shown in FIG. 11, in a film formation cycle on and after an m1-th time (where m1 is an integer of 2 or more and n or less, i.e., 2 ≦ m1 ≦ n), the supply time of the first modifying gas supplied to the substrate 200 in (a) is made to be shorter than that in the film formation cycle on and before an (m1-1)-th time. Instead of shortening the supply time of the first modifying gas, (a) may not be performed. As the cycle proceeds, the recess 300 becomes shallower, which makes it possible to form a void-free film without reducing the adsorption amount the first modifying gas or without causing the first modifying gas to be adsorbed. Accordingly, since suppression of adsorption of the precursor gas by the first modifying gas on the recess 300 is reduced or eliminated, the productivity may be increased while improving the step coverage or suppressing the occurrence of voids.

Similarly, in the film formation cycle on and after an m2-th time (where m2 is an integer of 2 or more and n or less, i.e., 2 ≦ m2 ≦ n), the supply time of the second modifying gas supplied to the substrate 200 in (c) may be made to be shorter than that in the film formation cycle on and before an (m2-1)-th time, or (c) may not be performed.

FIG. 11 shows the film formation sequence according to the fifth modification, showing the example in which m2 is set to a number greater than m1 (m1 < m2), but the present disclosure is not limited thereto. That is, the film formation sequence according to the fifth modification may be performed by setting m1 to a number greater than m2 (m2 < m1). Further, the film formation sequence according to the fifth modification may be performed by setting m1 and m2 to an equal number (m1 = m2). When m2 is set to a number greater than m1 (m1 < m2), it is more difficult to suppress the reaction between the reaction gas and the precursor gas by the second modifying gas than to suppress the adsorption of the precursor gas by the first modifying gas, making it possible to reduce the unreacted precursor gas, which is desirable.

In the above-described embodiments, as the precursor gas, for example, a gas containing a metal element may be used. As the metal element, for example, tantalum (Ta), tungsten (W), titanium (Ti), cobalt (Co), yttrium (Y), ruthenium (Ru), aluminum (Al), hafnium (Hf), zirconium (Zr), molybdenum (Mo), niobium (Nb), manganese (Mn), nickel (Ni), silicon (Si), or the like may be used. An appropriate application is also possible when forming any one of a nitride film, an oxide film, a carbide film, and a boride film containing the elements, or a composite film thereof.

When forming a film containing the above-mentioned metal element, it is possible to use, as a precursor gas, a Ta-containing gas, a W-containing gas, a Ti-containing gas, a Co-containing gas, a Y-containing gas, a Ru-containing gas, an Al-containing gas, a Hf-containing gas, a Zr-containing gas, a Mo-containing gas, a Nb-containing gas, a Mn-containing gas, a Ni-containing gas, a Si-containing gas, or the like.

When forming a film containing the above-mentioned metal element, a gas containing the metal element and a halogen element may be used. Examples of the gas containing the metal element and the halogen element may include tantalum pentachloride (TaCl₅), tantalum pentafluoride (TaF₅), tungsten hexachloride (WCl₆), tungsten hexafluoride (WF₆), titanium tetrachloride (TiCl₄), titanium tetrafluoride (TiF₄), cobalt dichloride (CoCl₂), cobalt dichloride (CoF₂), yttrium trichloride (YCl₃), yttrium trifluoride (YF₃), ruthenium trichloride (RuCl₃), ruthenium trifluoride (RuF₃), aluminum trichloride (AlCl₃), aluminum trifluoride (AlF₃), hafnium tetrachloride (HfCl₄), hafnium tetrafluoride (HfF₄), zirconium tetrachloride (ZrCl₄), zirconium tetrafluoride (ZrF₄), molybdenum pentafluoride (MoF₅), molybdenum pentachloride (MoCl₅), niobium trifluoride (NbF₃), niobium trichloride (NbCl₃), manganese difluoride (MnF₂), manganese dichloride (MnCl₂), nickel difluoride (NiF₂), nickel dichloride (NiCl₂), tetrachlorosilane, i.e., silicon tetrachloride (SiCl₄, abbreviated as STC), dichlorosilane (SiH₂Cl₂, abbreviated as DCS), monochlorosilane (SiH₃Cl, abbreviated as MCS), hexachlorodisilane, i.e., disilicon hexachloride (Si₂Cl₆, abbreviated as HCDS), and the like.

When forming a film containing the above-mentioned element, for example, a reducing gas may be used as the reaction gas. When the reducing gas is used as the reaction gas, it is possible to suppress oxidation of a substrate surface or a formed film, thereby suppressing an increase in electrical resistance of the film. Examples of the reducing gas may include a H₂ gas, a deuterium (D₂) gas, a borane (BH₃) gas, a diborane (B₂H₆) gas, a carbon monoxide (CO) gas, an ammonia (NH₃) gas, a monosilane (SiH₄) gas, a disilane (Si₂H₆) gas, a trisilane (Si₃H₈) gas, a monogermane (GeH₄) gas, a digermane (Ge₂H₆), ethanol (C₂H₅OH), and formic acid (HCOOH). In addition, gases obtained by plasma excitation of these gases may be used.

In addition, when forming a film containing the above-mentioned elements, for example, a nitrogen (N)-containing gas may be used as the reaction gas. Examples of the N-containing gas include a nitrogen (N₂) gas, a nitrous oxide (N₂O) gas, and gases containing N-H bonds such as an ammonia (NH₃) gas, a diazene (N₂H₂) gas, a hydrazine (N₂H₄) gas, a N₃H₈ gas and the like. As the gas containing N-H bonds, in addition to the above-mentioned gases, organic hydrazine-based gases, for example, methylhydrazine-based gases such as a monomethylhydrazine ((CH₃)HN₂H₂, abbreviated as MMH) gas, a dimethylhydrazine ((CH₃)₂N₂H₂, abbreviated as DMH) gas, a trimethylhydrazine ((CH₃)₂N₂(CH₃)H, abbreviated as TMH) gas and the like, and ethylhydrazine-based gases such as an ethylhydrazine ((C₂H₅)HN₂H₂, abbreviated as EH) gas and the like may be used. Further, ethylamine-based gases such as a triethylamine ((C₂H₅)₃N, abbreviated as TEA) gas, a diethylamine ((C₂H₅)₂NH, abbreviated as DEA) gas, a monoethylamine (C₂H₅NH₂, abbreviated as MEA) gas and the like, methylamine-based gases such as a trimethylamine ((CH₃)₃N, abbreviated as TMA) gas, a dimethylamine ((CH₃)₂NH, abbreviated as DMA) gas, a monomethylamine (CH₃NH₂, abbreviated as MMA) gas and the like, propylamine-based gases such as a tripropylamine ((C₃H₇)₃N, abbreviated as TPA) gas, a dipropylamine ((C₃H₇)₂NH, abbreviated as DPA) gas, a monopropylamine (C₃H₇NH₂, abbreviated as MPA) gas and the like, isopropylamine-based gases such as a triisopropylamine ([(CH₃)₂CH]₃N, abbreviated as TIPA) gas, a diisopropylamine ([(CH₃)₂CH]₂NH, abbreviated as DIPA) gas, a monoisopropylamine ((CH₃)₂CHNH₂, abbreviated as MIPA) gas and the like, butylamine-based gases such as a tributylamine ((C₄H₉)₃N, abbreviated as TBA) gas, a dibutylamine ((C₄H₉)₂NH, abbreviated as DBA) gas, a monobutylamine (C₄H₉NH₂, abbreviated as MBA) gas and the like, or isobutylamine-based gases such as a triisobutylamine ([(CH₃)₂CHCH₂]₃N, abbreviated as TIBA) gas, a diisobutylamine ([(CH₃)₂CHCH₂]₂NH, abbreviated as DIBA) gas, a monoisobutylamine ((CH₃)₂CHCH₂NH₂, abbreviated as MIBA) gas and the like may be used. Further, gases obtained by plasma excitation of these gases may be used. That is, as the amine-based gas, for example, at least one selected from the group of gases represented by composition formulas of (C₂H₅)ₓNH₃₋ₓ, (CH₃)ₓNH₃₋ₓ, (C₃H₇)ₓNH₃₋ₓ, [(CH₃)₂CH]ₓNH₃₋ₓ, (C₄H₉)ₓNH₃₋ₓ, and [(CH₃)₂CHCH₂]ₓNH₃₋ₓ (where x is an integer of 1 to 3) may be used. When an organic hydrazine-based gas or an amine-based gas is used, since reactivity may be increased and carbon (C) may be introduced into a film, a work function of the film may be regulated by controlling a C concentration.

For example, inorganic halogen element-containing gas (halogen-based gas) may be used as the first modifying gas and the second modifying gas. The inorganic halogen element-containing gas does not contain C, which is easily introduced into a film, and is constituted by a halogen element, which is easily desorbed from the film, making it possible to suppress an influence on the electrical characteristics. For example, a hydrogen halide gas (hydrogen halide) may be used as the inorganic halogen element-containing gas. For example, hydrogen fluoride (HF), hydrogen chloride (HCl), hydrogen bromide (HBr), hydrogen iodide (HI), or the like may be used as the hydrogen halide. Further, inorganic halogen element-containing gas other than the hydrogen halide gas, for example, a chlorine (Cl₂) gas, a fluorine (F₂) gas, a NF₃ gas, a tungsten hexafluoride (WF₆) gas, and the like may be used as the first modifying gas or the second modifying gas. Further, different gases may be used as the first modifying gas and the second modifying gas.

As the etching gas, for example, a gas containing a halogen element may be used. As the gas containing the halogen element, for example, a chlorine (Cl₂) gas, a fluorine (F₂) gas, a NF₃ gas, a HF gas, or a HCl gas may be used.

In the above-described embodiments, the example in which the N₂ gas is used as the inert gas is described, but the present disclosure is not limited thereto. A rare gas such as an argon (Ar) gas, a helium (He) gas, a neon (Ne) gas, or a xenon (Xe) gas may be used as the inert gas.

Although the present disclosure are specifically described above based on the examples, it goes without saying that the present disclosure is not limited to the embodiments and examples described above, and various modifications may be made. Further, the above-described embodiments and modifications may be used in appropriate combination. Processing procedures and processing conditions in this case may be, for example, the same as the processing procedures and processing conditions of the above-described embodiments and modifications.

### EXPLANATION OF REFERENCE NUMERALS

200: wafers (substrates)
201: process chamber
248: integrated supply system
121: controller (control part)

## Claims

1. A method of processing a substrate, comprising:
performing a cycle a predetermined number of times on the substrate, the cycle including sequentially performing:
(a) supplying a first modifying gas, which is an inorganic halogen element-containing gas;
(b) supplying a precursor gas;
(c) supplying a second modifying gas, which is an inorganic halogen element-containing gas; and
(d) supplying a reaction gas.

2. The method of Claim 1, wherein a region where the second modifying gas is adsorbed on the substrate in (c) is made to be smaller than a region where the first modifying gas is adsorbed on the substrate in (a).

3. The method of Claim 1, wherein the substrate includes a recess.

4. The method of Claim 3, wherein an amount of the second modifying gas adsorbed on a bottom side of the recess in (c) is made to be smaller than an amount of the first modifying gas adsorbed on the bottom side of the recess in (a).

5. The method of Claim 3, wherein an amount of the second modifying gas adsorbed on a top side of the recess in (c) is made to be larger than an amount of the first modifying gas adsorbed on the top side of the recess in (a).

6. The method of any one of Claims 2, 4, and 5, wherein a partial pressure of the second modifying gas in a space in which the substrate is placed in (c) is lower than a partial pressure of the first modifying gas in the space in (a).

7. The method of Claim 6, wherein a flow rate of the second modifying gas supplied to the substrate per unit time in (c) is less than a flow rate of the first modifying gas supplied to the substrate per unit time in (a).

8. The method of Claim 6, wherein a time to supply the second modifying gas to the substrate in (c) is made to be longer than a time to supply the first modifying gas to the substrate in (a).

9. The method of any one of Claims 2, 4, and 5, wherein a time to supply the second modifying gas to the substrate in (c) is made to be shorter than a time to supply the first modifying gas to the substrate in (a).

10. The method of Claim 1, wherein in the cycle on and after an n1-th time (where n1 is an integer of 2 or more), a partial pressure of the first modifying gas in a space in (a) is made to be lower than a partial pressure of the first modifying gas in the cycle on and before an (n1-1)-th time, or (a) is not performed.

11. The method of Claim 1, wherein in the cycle on and after an n2-th time (where n2 is an integer of 2 or more), a partial pressure of the second modifying gas in a space in (c) is made to be lower than a partial pressure of the second modifying gas in the cycle on and before an (n2-1)-th time, or (c) is not performed.

12. The method of Claim 1, wherein in the cycle on and after an m1-th time (where m1 is an integer of 2 or more), a time to supply the first modifying gas to the substrate in (a) is made to be shorter than a time to supply the first modifying gas to the substrate in the cycle on and before an (m1-1)-th time, or (a) is not performed.

13. The method of Claim 1, wherein in the cycle on and after an m2-th time (where m2 is an integer of 2 or more), a time to supply the second modifying gas to the substrate in (c) is made to be shorter than a time to supply the second modifying gas to the substrate in the cycle on and before an (m2-1)-th time, or (c) is not performed.

14. The method of Claim 1, wherein the cycle on at least one of the predetermined number of times further includes (e) supplying an etching gas to the substrate after performing (d).

15. The method of Claim 14, wherein the etching gas is a gas containing a halogen element.

16. The method of Claim 1, wherein the precursor gas is a gas containing a metal element and a halogen element, and the reaction gas is a reducing gas.

17. The method of Claim 1, wherein the first modifying gas and the second modifying gas are the same gas.

18. A method of manufacturing a semiconductor device, comprising:
performing a cycle a predetermined number of times on the substrate, the cycle including sequentially performing:
(a) supplying a first modifying gas, which is an inorganic halogen element-containing gas;
(b) supplying a precursor gas;
(c) supplying a second modifying gas, which is an inorganic halogen element-containing gas; and
(d) supplying a reaction gas.

19. A substrate processing apparatus, comprising:
a process chamber in which a substrate is processed;
a first modifying gas supply system configured to supply a first modifying gas, which is an inorganic halogen element-containing gas, to the substrate;
a second modifying gas supply system configured to supply a second modifying gas, which is an inorganic halogen element-containing gas, to the substrate;
a precursor gas supply system configured to supply a precursor gas to the substrate;
a reaction gas supply system configured to supply a reaction gas to the substrate; and
a controller configured to be capable of controlling the first modifying gas supply system, the second modifying gas supply system, the precursor gas supply system, and the reaction gas supply system so as to perform a cycle a predetermined number of times on the substrate, the cycle including sequentially performing:
(a) supplying the first modifying gas;
(b) supplying the precursor gas;
(c) supplying the second modifying gas; and
(d) supplying the reaction gas.

20. A program that causes, by a computer, a substrate processing apparatus to perform a cycle a predetermined number of times on a substrate, the cycle including sequentially performing:
(a) supplying a first modifying gas, which is an inorganic halogen element-containing gas;
(b) supplying a precursor gas;
(c) supplying a second modifying gas, which is an inorganic halogen element-containing gas; and
(d) supplying a reaction gas.
